Europäisches Patentamt

European Patent Office

Office européen des brevets

(19)

(11) **EP 0 483 450 B1**

(12) **EUROPÄISCHE PATENTSCHRIFT**

(45) Veröffentlichungstag und Bekanntmachung des Hinweises auf die Patenterteilung:
**18.09.1996  Patentblatt 1996/38**

(51) Int Cl.⁶: **H03K 17/08**, H02H 3/08, H02H 3/12, G01R 31/02

(21) Anmeldenummer: **91106400.4**

(22) Anmeldetag: **20.04.1991**

(54) **Als Baustein ausgebildete Schaltungsanordnung mit mindestens einem Halbleiterschalter zum Schalten einer Last**

Component circuit with at least one semiconductor switch for switching a load

Dispositif de circuit en tant qu'élément avec au moins un actionneur semi-conducteur pour mettre en circuit

(84) Benannte Vertragsstaaten:
**DE ES FR GB IT NL SE**

(30) Priorität: **31.10.1990  DE 4034569**

(43) Veröffentlichungstag der Anmeldung:
**06.05.1992   Patentblatt 1992/19**

(73) Patentinhaber: **VDO Adolf Schindling AG
D-60487 Frankfurt (DE)**

(72) Erfinder:
• **Blümel, Thomas
  W-6384 Schmitten 1 (DE)**
• **Meicher, Joachim
  W-6238 Hofheim (DE)**
• **Lukas, Bernhard
  W-6096 Raunheim (DE)**
• **Kares, Walter
  W-6000 Frankfurt 60 (DE)**

(74) Vertreter: **Klein, Thomas, Dipl.-Ing. (FH)
Sodener Strasse 9
65824 Schwalbach/Ts. (DE)**

(56) Entgegenhaltungen:
EP-A- 0 082 493          EP-A- 0 197 707
EP-A- 0 350 299          DE-A- 3 102 267
DE-A- 3 123 816          DE-A- 3 203 513
DE-A- 3 842 169          US-A- 4 831 483

**Beschreibung**

Die Erfindung betrifft eine als Baustein ausgebildete Schaltungsanordnung mit mindestens einem Halbleiterschalter zum Schalten einer Last, insbesondere eines Stellgliedes in Steuerungs- oder Regeleinrichtungen, wobei für jeweils einen Halbleiterschalter eine Kurzschluß-Überwachungsschaltung und eine Leerlauf-Überwachungsschaltung mit je einem Ausgangsanschluß vorgesehen sind.

Steuerungs- oder Regeleinrichtungen werden häufig aus einzelnen Bausteinen zusammengesetzt, die meistens als integrierte Schaltungen ausgebildet sind. Dazu sind beispielsweise sogenannte Treiber-Bausteine bekannt, in denen sich eine oder mehrere Endstufen zum Schalten von Lasten befinden. In elektronischen Systemen für Kraftfahrzeuge werden derartige Treiber-Bausteine beispielsweise zum Schalten von Einspritzventilen, für die Tankregenerierung und für die Abgasrückführung angewendet.

Bei Steuerung- oder Regeleinrichtungen, die sicherheits- oder abgasrelevante Funktionen erfüllen, ist eine weitgehende Diagnose von gegebenenfalls auftretenden Fehlern erforderlich. Zur Unterstützung einer derartigen Diagnose sind Treiber-Bausteine bekanntgeworden, welche über einen einzigen Anschluß beim Auftreten verschiedener Fehler eine gemeinsame Fehlermeldung ausgeben.

Gemäß der US-PS 48 31 483 ist eine Schaltungsanordnung bekannt, die einen Halbleiterschalter zum Schalten einer Last aufweist. Für den Halbleiterschalter ist eine Kurzschluß-Überwachungsschaltung und eine Leerlauf-Überwachungsschaltung mit je einem Ausgangsanschluß vorgesehen.

Aufgabe der vorliegenden Erfindung ist es, eine als Baustein ausgebildete Schaltungsanordnung mit mindestens einem Halbleiterschalter zum Schalten einer Last anzugeben, bei welcher verschiedenartige Fehlermeldungen im Falle eines Kurzschlusses oder eines Leerlaufs ausgegeben werden.

Bei den meisten Anwendungen der erfindungsgemäßen Schaltungsanordnung wird der Strom durch eine induktive Last pulsierend geschaltet, wobei der Strom innerhalb einer jeden leitenden Phase des Halbleiterschalters allmählich ansteigt. Um zu Beginn einer leitenden Phase, also bei noch sehr kleinem Strom, keine Fehlermeldung zu erhalten, ist erfindungsgemäß vorgesehen, daß bei einer pulsierenden Ansteuerung des Halbleiterschalters ein Ausgangssignal der Leerlauf-Überwachungsschaltung erzeugt wird, das den zur Anzeige eines Leerlaufs vorgesehen Wert einnimmt, wenn während einer gesamten leitenden Phase des Halbleiterschalters der Strom durch den Halbleiterschalter unter einem vorgegebenen Wert bleibt.

Eine vorteilhafte Ausgestaltung der erfindungsgemäßen Schaltungsanordnung besteht darin, daß die Leerlauf-Überwachungsschaltung von einer ersten Schwellwertschaltung, einem ersten Tiefpaß und einem ersten Flip-Flop und die Kurzschluß-Überwachungsschaltung von einer zweiten Schwellwertschaltung, einem zweiten Tiefpaß und einem zweiten Flip-Flop gebildet ist.

Dabei kann zum schnellen Abschalten des Halbleiterschalters im Kurzschluß-Fall vorgesehen sein, daß das Ausgangssignal der zweiten Schwellwertschaltung die Zuführung des Steuersignals zur Steuerelektrode des Halbleiterschalters steuert. Da jedoch durch das dann erfolgende Ausbleiben des Stroms durch den Halbleiterschalter das Steuersignal der Steuerelektrode des Halbleiterschalters wieder zugeführt wird, erfolgt hierbei keine endgültige Abschaltung. Eine solche kann dadurch erreicht werden, daß gemäß einer anderen Weiterbildung ein weiteres Ausgangssignal des zweiten Flip-Flops die Zuführung des Steuersignals zur Steuerelektrode des Halbleiterschalters steuert. Hierdurch bleibt der Halbleiterschalter bis zum Abschalten der Betriebsspannung im nichtleitenden Zustand.

Eine andere Weiterbildung der Erfindung besteht darin, daß in dem Baustein ein Temperatursensor vorgesehen ist, dessen Ausgangssignal die Kurzschluß-Überwachungsschaltungen derart steuert, daß bei Überschreiten einer vorgegebenen Temperatur die Ausgänge der Kurzschluß-Überwachungsschaltungen den für einen Kurzschluß vorgesehenen Wert ausgeben. Damit wird für alle in einem Baustein vorgesehenen Halbleiterschalter ein Kurzschluß gemeldet. Da Kurzschlüsse gleichzeitig an allen Ausgängen jedoch sehr unwahrscheinlich sind, wird eine derartige Fehlermeldung als thermische Überlastung angesehen.

Eine andere Weiterbildung der Erfindung ist dadurch gekennzeichnet, daß ein Umschalteingang vorgesehen ist und daß in Abhängigkeit von einer dem Umschalteingang zuführbaren Umschaltspannung die Schaltungsanordnung an verschiedene, vorzugsweise zwei verschiedene, Lastbereiche angepaßt ist.

Durch diese Weiterbildung kann in verschiedenen Lastbereichen ein gleich dimensionierter Baustein verwendet werden, wobei verschiedene Parameter, beispielsweise die Schwellwerte bei den Kurzschluß- und Leerlauf-Überwachungsschaltungen, die Amplitude des Steuersignals für den Halbleiterschalter und eine Begrenzung der Spannung am Halbleiterschalter an den jeweiligen Verwendungszweck angepaßt werden kann. Dazu ist in der den Baustein aufnehmenden Leiterplatte lediglich eine Verbindung des Umschalteingangs mit einem geeigneten Potential vorzusehen oder wegzulassen.

Durch die in weiteren Unteransprüchen aufgeführten Maßnahmen sind weitere vorteilhafte Weiterbildungen und Verbesserungen der im Hauptanspruch angegebenen Erfindung möglich.

Die Erfindung läßt zahlreiche Ausführungsformen zu. Eine davon ist schematisch in der Zeichnung anhand mehrerer Figuren dargestellt und nachfolgend beschrieben. Es zeigt:

Fig. 1 ein Blockschaltbild des Ausführungsbeispiels und

Fig. 2 ein Blockschaltbild einer Steuereinrichtung mit einer erfindungsgemäßen Schaltungsanordnung.

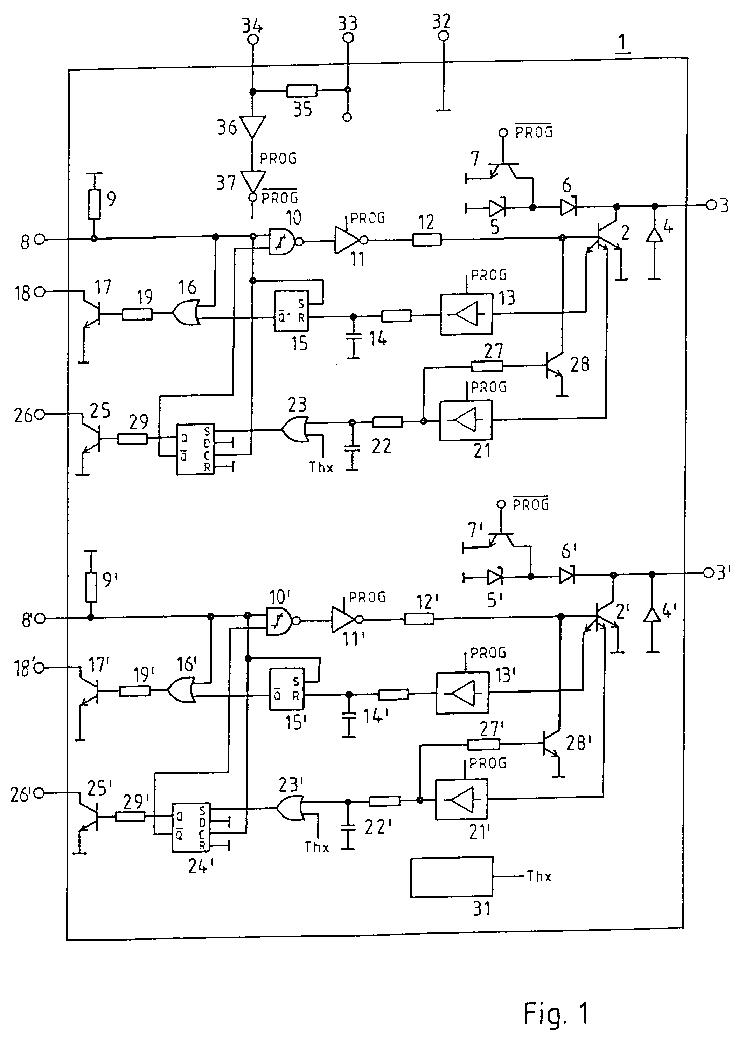

Gleiche Teile sind in den Figuren mit gleichen Bezugszeichen versehen. Der in Fig. 1 dargestellte Baustein 1 enthält zwei identische Schaltungen mit je einem Halbleiterschalter, der als Endstufe (Treiber) beispielsweise für verschiedene Stellglieder in einem Kraftfahrzeug geeignet ist und dem Halbleiter jeweils zugeordnete Schaltungen. Im folgenden wird daher nur die Schaltung mit den Bezugszeichen 2 bis 29 beschrieben, während die Elemente der anderen Schaltung mit den Bezugszeichen 2' bis 29' versehen sind.

Die Endstufe wird von einem Multi-Emitter-Transistor 2 gebildet, dessen einer Emitter mit Masse und dessen Kollektor mit einem Ausgang 3 verbunden ist. Da die Schaltungsanordnung im wesentlichen zum Schalten von induktiven Verbrauchern vorgesehen ist, sind dem Transistor 2 eine Verpolschutzdiode 4 und Freilaufdioden 5, 6 parallelgeschaltet, wobei die in Reihe geschalteten Z-Dioden 5, 6 ferner einen Schutz des Transistors 2 vor Überspannungen bewirken. Durch Überbrücken der Z-Diode 5 mit Hilfe eines Transistors 7 kann die Begrenzungsspannung herabgesetzt werden.

Ein Steuersignal für den Transistor 2 wird über einen Eingang 8 zugeführt, der über einen Eingangswiderstand 9 mit Masse verbunden ist. Das Steuersignal gelangt über eine Nicht-Und-Schaltung 10, einen invertierenden Verstärker 11, dessen Verstärkungsgrad einstellbar ist, und einen Widerstand 12 zur Basis des Transistors 2.

Zum Erkennen von Fehlern im Bereich des Ausgangs 3 sind eine Leerlauf-Überwachungsschaltung und eine Kurzschluß-Überwachungsschaltung vorgesehen. Die Leerlauf-Überwachungsschaltung spricht an, wenn der Strom durch den Transistor 2 unterhalb einer vorgegebenen Schwelle liegt, wenn also eine Leitungsunterbrechung zwischen dem Kollektor des Transistors 2, dem Verbraucher, innerhalb des Verbrauchers oder zwischen dem Verbraucher und der positiven Betriebsspannung vorliegt. Außerdem reagiert die Leerlauf-Überwachungsschaltung bei einem Kurzschluß des Ausgangs 3 gegen Masse.

Die Kurzschluß-Überwachungsschaltung spricht an, wenn der Strom durch den Transistor 2 einen weiteren vorgegebenen Wert überschreitet, was im wesentlichen bei einem Schluß zwischen dem Ausgang 3 oder der Leitung zum Verbraucher einerseits und dem positiven Pol der Betriebsspannungsquelle andererseits der Fall ist.

Die Leerlauf-Überwachungsschaltung wird von einer Schwellwertschaltung 13, einem Tiefpaß 14, einem Flip-Flop 15, einer Oder-Schaltung 16 und einem Ausgangs-Transistor 17 gebildet. An einem Ausgang 18 ist ein Signal entnehmbar, welches einen Leerlauf, also beispielsweise einen Leitungsbruch, anzeigt.

Die Schwellwertschaltung 13 erzeugt ein Ausgangssignal, das bei Überschreiten eines vorgegebenen Wertes des Stroms durch den Transistor 2 positiv wird. Dieser vorgegebene Wert liegt unterhalb des für den jeweiligen Verbraucher zu erwartenden Stroms, wobei Toleranzen der einzelnen Verbraucher und zeitliche und thermische Schwankungen zu berücksichtigen sind. Mit dem Tiefpaß 14, der beispielsweise eine Zeitkonstante von 200 μs aufweist, werden kurzzeitige Störungen unterdrückt.

Das Flip-Flop 15 wird mit Beginn jeweils eines den Transistor 2 in den leitenden Zustand steuernden Steuerimpulses gesetzt. Am Ausgang $\bar{Q}$ steht dann der Wert L an. Durch die Oder-Verknüpfung 16 mit dem Steuersignal, das zu dieser Zeit den Wert H aufweist, entsteht am Ausgang der Oder-Schaltung ebenfalls ein positives Signal (H), das über den Widerstand 19 den Transistor 17 in leitenden Zustand steuert. Der Ausgang 18 erhält damit den Pegel L.

Steigt während der leitenden Phase des Transistors 2 der Strom über den Schwellwert, was bei störungsfreiem Betrieb auch bei induktiven Verbrauchern der Fall ist, wird das Flip-Flop 15 zurückgesetzt. Am Ende der leitenden Phase nimmt das Steuersignal den Wert L an, so daß wegen der Oder-Verknüpfung bei 16 das Signal am Ausgang 18 vom Pegel am Ausgang $\bar{Q}$ abhängig ist. Da das Flip-Flop 15 zurückgesetzt worden ist, liegt am Ausgang $\bar{Q}$ der Pegel H an, so daß der Transistor 17 weiterhin leitend ist und am Ausgang 18 der Pegel L herrscht.

Hat jedoch der Strom durch den Transistor 2 während der leitenden Phase nicht den vorgegebenen Wert überschritten, bleibt das Flip-Flop 15 gesetzt, so daß der Ausgang $\bar{Q}$ weiterhin den Pegel L führt. Dieses führt zu einem Sperren des Transistors 17, so daß am Ausgang 18 der Pegel H als Fehlermeldung ausgegeben wird.

Die Kurzschluß-Überwachungsschaltung besteht aus einer Schwellwertschaltung 21, einem Tiefpaß 22, einer Oder-Schaltung 23, einem Flip-Flop 24 und einem Ausgangs-Transistor 25, dessen Kollektor einen Ausgang 26 bildet. Das Ausgangssignal der Schwellwertschaltung 21 springt auf einen positiven Wert, wenn der Strom durch den Transistor 2 einen Wert übersteigt, der oberhalb der beim normalen Betrieb zu erwartenden Ströme liegt. Der Tiefpaß 2 dient zur Unterdrückung von kurzzeitigen Störungen. Um einer Überlastung des Transistors 2 möglichst schnell zu begegnen, ist an den Ausgang der Schwellwertschaltung 21 über einen Widerstand 27 die Basis eines Transistors 28 angeschlossen, der die Basis des Transistors 2 im Kurzschlußfall mit Masse verbindet und somit eine weitere Ansteuerung verhindert. Dadurch wird der Strom auf einen Wert begrenzt, bei dem der Transistor noch nicht überlastet wird, und der genügt, um das Flip-Flop 24 zu setzen, das von den Steuersignalen getaktet wird.

Durch das Setzen des Flip-Flops 24 wird der über einen Widerstand 29 mit dem Ausgang Q des Flip-Flops 24 verbundene Transistor 25 leitend, so daß im Falle eines Kurzschlusses der Ausgang 26 den Pegel L einnimmt. Gleichzeitig wird durch die Verbindung des Ausgangs Q des Flip-Flops 24 mit der Nicht-Und-Schaltung 10 eine weitere Zuführung der Steuersignale zum Transistor 2 solange unterbunden, bis das Steuersignal am Eingang 8 wieder einen Wechsel von Pegel L nach Pegel H macht, und damit das Flip-Flop 24 wieder zurückgesetzt wird.

In dem Baustein 1 ist ferner ein Temperatursensor 31 vorgesehen, der ein Signal Thx abgibt, welches bei Überschreiten eines zulässigen Temperaturwertes den Pegel H einnimmt. Dieses Signal wird den Oder-Schaltungen 23, 23' zugeführt und löst damit in beiden Schaltungen eine Kurzschluß-Fehlermeldung aus. Da ein gleichzeitiger Kurzschluß bei beiden Ausgängen 3, 3' äußerst unwahrscheinlich ist, kann ein angeschlossener Mikrocomputer daran erkennen, daß mit großer Sicherheit eine thermische Überlastung vorliegt.

Über einen Anschluß 32 kann der Baustein 1 mit Massepotential bzw. mit dem negativen Pol der Betriebsspannungsquelle verbunden werden. Ein Anschluß 33 dient zur Zuführung der positiven Betriebsspannung. Mit Hilfe eines weiteren Anschlusses 34 kann der Baustein für zwei verschiedene Lastbereiche umgeschaltet werden. Über einen Widerstand 35 ist der Anschluß 34 mit der positiven Betriebsspannung beaufschlagt.

Wird der Baustein 1 in einer Steuereinrichtung mit geringen Lasten verwendet, so ist der Anschluß 34 mit Massepotential verbunden. Bei Steuereinrichtungen mit hohen Lasten bleibt der Anschluß 34 ohne weitere Verbindung. Über einen nichtinvertierenden Verstärker 36 wird die bei 34 zugeführte Umschaltspannung PROG einem Steuereingang des Verstärkers 11 und Steuereingängen der Schwellwertschaltungen 13, 21 zugeführt. Über einen invertierenden Verstärker 37 gelangt die invertierte Umschaltspannung $\overline{PROG}$ zur Basis des Transistors 7. Durch die Steuerung des Verstärkers 11 ist es möglich, den Basisstrom des Transistors 2 an die jeweilige Last, also an den maximalen Strom, anzupassen. Dadurch wird bei kleineren Lasten ein unnötig hoher Basisstrom vermieden. Die Steuerung der Schwellwertschaltungen 13, 21 ermöglicht eine Anpassung der Schwellwerte an die jeweils vorhandenen Lasten. Die Umschaltung der Spannungsbegrenzung kann beispielsweise derart ausgelegt sein, daß bei Einspritzventilen, die eine relativ hohe Rückschlagspannung aufweisen, die Begrenzung bei 80 V und bei anderen Lasten bei 27 V erfolgt.

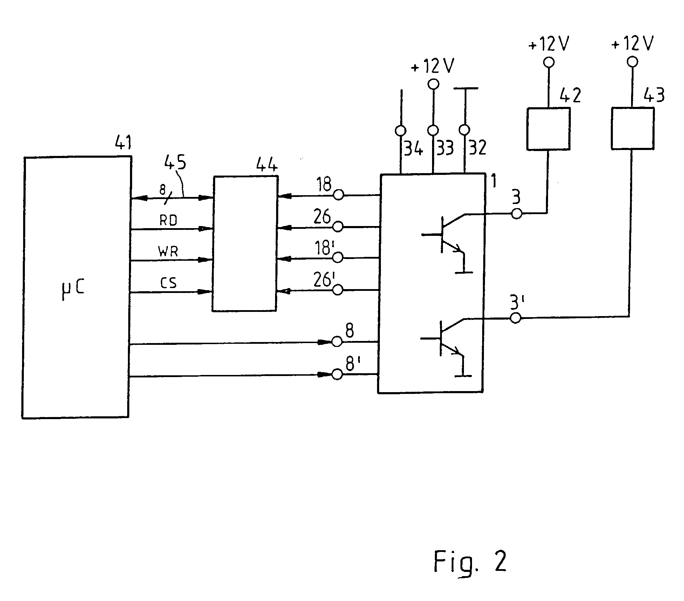

Fig. 2 zeigt Teile einer Steuereinrichtung unter Verwendung des Bausteins 1 gemäß Fig. 1. Dabei ist ein Mikrocomputer 41 vorgesehen, der Steuersignale erzeugt und über die Eingänge 8, 8' dem Baustein 1 zuführt. Die Ausgänge 3, 3' des Bausteins sind mit Einspritzventilen 42, 43 verbunden, denen ferner eine Spannung von +12 V zugeführt wird. Über Anschlüsse 33, 32 ist der Baustein an eine Betriebsspannungsquelle und an Massepotential angeschlossen. Zur Abfrage der Fehlermeldungen, die, wie im Zusammenhang mit Fig. 1 beschrieben, im Baustein 1 erzeugt werden, sind die Ausgänge 18, 26, 18', 26' mit Eingängen einer Porterweiterung 44 verbunden. Über eine Datenleitung 45 und zugehörige Steuerleitungen RD, WR und CS fragt der Computer 41 den Zustand der Ausgänge 18, 26, 18' und 26' ab. Entsprechend dem im Computer 41 abgelegten Programm können beim Vorliegen von Fehlermeldungen geeignete Schritte eingeleitet werden.

**Patentansprüche**

1. Als Baustein ausgebildete Schaltungsanordnung mit mindestens einem Halbleiterschalter zum Schalten einer Last, insbesondere eines Stellgliedes in Steuerungs- oder Regeleinrichtungen, wobei für jeweils einen Halbleiterschalter eine Kurzschluß-Überwachungsschaltung und eine Leerlauf-Überwachungsschaltung mit je einem Ausgangsanschluß vorgesehen sind, dadurch gekennzeichnet, daß bei einer pulsierenden Ansteuerung des Halbleiterschalters (2) dieser sich abwechselnd in einer leitenden und nichtleitenden Phase befindet, wobei ein Ausgangssignal der Leerlauf-Überwachungsschaltung (13 bis 19) erzeugt wird, das, während einer nichtleitenden Phase des Halbleiterschalters (2), nur dann den zur Anzeige eines Leerlaufs vorgesehenen Wert einnimmt, wenn während der gesamten vorhergehenden leitenden Phase des Halbleiterschalters (2) der Strom durch den Halbleiterschalter (2) unter einem vorgegebenen Wert geblieben ist.

2. Schaltungsanordnung nach dem Anspruch 1, dadurch gekennzeichnet, daß die Leerlauf-Überwachungsschaltung von einer ersten Schwellwertschaltung (13), einem ersten Tiefpaß (14) und einem ersten Flip-Flop (15) und die Kurzschluß-Überwachungsschaltung von einer zweiten Schwellwertschaltung (21), einem zweiten Tiefpaß (22) und einem zweiten Flip-Flop (24) gebildet ist.

3. Schaltungsanordnung nach Anspruch 2, dadurch gekennzeichnet, daß das erste Flip-Flop (15) vom Ausgangssignal des ersten Tiefpasses (14) rücksetzbar und von einem zugeführten impulsförmigen Steuersignal setzbar ist und daß ein Ausgangssignal des ersten Flip-Flops (15) zur Bildung eines Ausgangssignals der Leerlauf-Überwachungsschaltung mit dem Steuersignal verknüpft wird.

4. Schaltungsanordnung nach Anspruch 2, dadurch gekennzeichnet, daß das zweite Flip-Flop (24) vom Ausgangssignal des zweiten Tiefpasses (22) setzbar ist und von einem zugeführten impulsförmigen Steuersignal getaktet wird und daß ein Ausgangssignal des zweiten Flip-Flops (24) das Ausgangssignal der Kurzschluß-Überwachungsschaltung bildet.

5. Schaltungsanordnung nach Anspruch 4, dadurch gekennzeichnet, daß das Ausgangssignal der zweiten Schwellwertschaltung (21) die Zuführung des Steuersignals zur Steuerelektrode des Halbleiterschalters (2) steuert.

6. Schaltungsanordnung nach Anspruch 4, dadurch gekennzeichnet, daß ein weiteres Ausgangssignal des zweiten Flip-Flops (24) die Zuführung des Steuersignals zur Steuerelektrode des Halbleiterschalters (2) steuert.

7. Schaltungsanordnung nach einem der vorhergehenden Ansprüche, dadurch gekennzeichnet, daß in dem Baustein (1) ein Temperatursensor (30) vorgesehen ist, dessen Ausgangssignal die Kurzschluß-Kurzschluß-Überwachungsschaltungen (21 bis 26, 21' bis 26') derart steuert, daß bei Überschreiten einer vorgegebenen Temperatur die Ausgänge (26, 26') der Kurzschluß-Überwachungsschaltungen (21 bis 26, 21' bis 26') den für einen Kurzschluß vorgesehenen Wert ausgeben.

8. Schaltungsanordnung nach einem der vorhergehenden Ansprüche, dadurch gekennzeichnet, daß der Halbleiterschalter (2) ein Multi-Emitter-Transistor ist, wobei ein Emitter mit Masse und zwei weitere Emitter mit je einem Eingang der Kurzschluß-Überwachungsschaltung (21 bis 26) und der Leerlauf-Überwachungsschaltung (13 bis 19) verbunden sind.

9. Schaltungsanordnung nach einem der vorhergehenden Ansprüche, dadurch gekennzeichnet, daß ein Umschalteingang (34) vorgesehen ist, und daß in Abhängigkeit von einer dem Umschalteingang (34) zuführbaren Umschaltspannung die Schaltungsanordnung an verschiedene, vorzugsweise zwei verschiedene, Lastbereiche angepaßt ist.

10. Schaltungsanordnung nach Anspruch 9, dadurch gekennzeichnet, daß die Amplitude eines Steuersignals, das der Steuerelektrode des Halbleiterschalters (2) zuführbar ist, von der Umschaltspannung abhängig ist.

11. Schaltungsanordnung nach einem der Ansprüche 9 oder 10, dadurch gekennzeichnet, daß Schwellwerte, bei denen die Kurzschluß-Überwachungsschaltung (21 bis 26) und die Leerlauf-Überwachungsschaltung (13 bis 19) ansprechen, von der Umschaltspannung abhängig sind.

12. Schaltungsanordnung nach einem der Ansprüche 9 bis 11, dadurch gekennzeichnet, daß eine Begrenzung der Spannung am Halbleiterschalter (2) von der Umschaltspannung abhängig ist.

## Claims

1. A circuit arrangement constructed as a component, having at least one semiconductor switch for switching a load, particularly of an actuator in control or regulating devices, wherein a short-circuit monitoring circuit and an open circuit monitoring circuit are each provided with an output connection for each semiconductor switch, characterised in that when there is pulsed triggering of the semiconductor switch (2) the latter is situated alternately in a conducting and non-conducting phase, wherein an output signal of the open circuit monitoring circuit (13 to 19) is generated which only assumes the scheduled value for indicating an open circuit during a non-conducting phase of the semiconductor switch (2) if the current through the semiconductor switch (2) has remained below a predetermined value during the entire preceding conducting phase of the semiconductor switch (2).

2. A circuit arrangement according to claim 1, characterised in that the open circuit monitoring circuit is formed from a first threshold value circuit (13), a first low-pass filter (14) and a first flip-flop (15), and the short-circuit monitoring circuit is formed from a second threshold value circuit (21), a second low-pass filter (22) and a second flip-flop (24).

3. A circuit arrangement according to claim 2, characterised in that the first flip-flop (15) can be reset by the output signal of the first low-pass filter (14) and can be set by a pulsed control signal which is supplied, and that an output signal of the first flip-flop (15) is combined with the control signal to form an output signal of the open circuit monitoring circuit.

4. A circuit arrangement according to claim 2, characterised in that the second flip-flop (24) can be set by the output signal of the second low-pass filter (22) and is supplied by clock pulses by a pulsed control signal which is supplied, and that an output signal of the second flip-flop (24) forms the output signal of the short-circuit monitoring circuit.

5. A circuit arrangement according to claim 4, characterised in that the output signal of the second threshold value circuit (21) controls the supply of the control signal to the control electrode of the semiconductor switch (2).

6. A circuit arrangement according to claim 4, characterised in that a further output signal of the second flip-flop (24) controls the supply of the control signal to the control electrode of the semiconductor switch (2).

7. A circuit arrangement according to any one of the preceding claims, characterised in that a temperature sensor (30) is provided in the component (1), the output signal of which temperature sensor controls the short-circuit monitoring circuits (21 to 26, 21' to 26') in such a way that when a predetermined temperature is exceeded the outputs (26, 26') of the short-circuit monitoring circuits (21 to 26, 21' to 26') emit the scheduled value for a short-circuit.

8. A circuit arrangement according to any one of the preceding claims, characterised in that the semiconductor switch (2) is a multi-emitter transistor, wherein one emitter is connected to earth and two further emitters are each connected to an input of the short-circuit monitoring circuit (21 to 26) and of the open circuit monitoring circuit 13 to 19).

9. A circuit arrangement according to any one of the preceding claims, characterised in that a switch-over input (34) is provided, and that the circuit arrangement is adapted to different, preferably two different, load ranges depending on a switch-over voltage which can be supplied to the switch-over input (34).

10. A circuit arrangement according to claim 9, characterised in that the amplitude of a control signal which can be supplied to the control electrode of the semiconductor switch (2) is dependent on the switch-over voltage.

11. A circuit arrangement according to either one of claims 9 or 10, characterised in that threshold values at which the short-circuit monitoring circuit (21 to 26) and the open circuit monitoring circuit (13 to 19) respond are dependent on the switch-over voltage.

12. A circuit arrangement according to any one of claims 9 to 11, characterised in that a delimitation of the voltage at the semiconductor switch (2) is dependent on the switch-over voltage.

**Revendications**

1. Dispositif de circuit du type circuit intégré comportant au moins un interrupteur du type semi-conducteur destiné à la commutation d'une charge, en particulier celle d'un organe de réglage dans des dispositifs de commande ou des dispositifs de régulation, un circuit de surveillance de court-circuit et un circuit de surveillance de ralenti étant prévus pour chaque semi-conducteur et étant munis chacun d'une connexion de sortie, caractérisé en ce que dans le cas d'une commande par impulsions de l'interrupteur (2) du type semi-conducteur, celui-ci se trouve alternativement dans une phase conductrice puis dans une phase non conductrice, qu'un signal de sortie du circuit (13 à 19) de surveillance de ralenti, est produit, qui ne prend la valeur prévue pour l'indication d'un ralenti, au cours d'une phase non conductrice de l'interrupteur (2) du type semi-conducteur, que lorsqu'au cours de l'ensemble de la phase conductrice précédente de l'interrupteur (2), du type semi-conducteur, le courant traversant l'interrupteur (2) du type semi-conducteur est resté en-dessous d'une valeur fixée à l'avance.

2. Dispositif de circuit selon la revendication 1, caractérisé en ce que le circuit de surveillance du ralenti est constitué d'un premier circuit (13) de valeur de seuil, d'un premier filtre passe-bas (14) et d'une première bascule ou flip-flop (15) et le circuit de surveillance de court-circuit est constitué d'un deuxième circuit (21) de valeur de seuil, d'un deuxième filtre passe-bas (22) et d'une deuxième bascule, ou flip-flop (24).

3. Dispositif de circuit selon la revendication 1, caractérisé en ce que la première bascule ou flip-flop (15) peut être ramené hors service par le signal de sortie du premier filtre passe-bas (14) et remise en marche par un signal de commande impulsionnel amené et qu'un signal de sortie de la première bascule, ou flip-flop (15) est combiné avec le signal de commande pour la formation d'un signal de sortie du circuit de surveillance de ralenti.

4. Dispositif de circuit selon la revendication 1, caractérisé en ce que la deuxième bascule, ou flip-flop, (24) peut être mise en marche par le signal de sortie du deuxième filtre passe-bas (22) et cadencée par un signal de commande impulsionnel amené et qu'un signal de sortie de la deuxième bascule, ou flip-flop (24) constitue le signal de sortie du circuit de surveillance de court-circuit.

5. Dispositif de circuit selon la revendication 4, caractérisé en ce que le signal de sortie du deuxième circuit (21) de valeur de seuil commande l'amenée du signal de commande à l'électrode de commande de l'interrupteur (2) du type semi-conducteur.

6. Dispositif de circuit selon la revendication 4, caractérisé en ce qu'un autre signal de sortie de la deuxième bascule, ou flip-flop (24), commande l'amenée du signal de commande à l'électrode de commande de l'interrupteur (2) du type semi-conducteur.

7. Dispositif de circuit selon l'une des revendications précédentes, caractérisé en ce que, dans le circuit intégré (1), est prévu un capteur de température dont le signal de sortie commande les circuits de surveillance de court-circuit (21 à 26, 21' à 26'),de façon telle qu'en cas de dépassement d'une température fixée à l'avance, les sorties (26, 26') des circuits de surveillance de court-circuit (21 à 26, 21' à 26') délivrent la valeur prévue pour un court-circuit.

8. Dispositif de circuit selon une des revendications précédentes, caractérisé en ce que l'interrupteur (2) du type semi-conducteur est un transistor multi-émetteur dans lequel un émetteur est connecté à la masse et deux autres émetteurs sont connectés chacun à une entrée du circuit de surveillance de court-circuit (21 à 26) et à une entrée du circuit de surveillance de ralenti (de 13 à 19).

9. Dispositif de circuit selon une des revendications précédentes, caractérisé en ce qu'une entrée (34) de commutation est prévue et que le dispositif de circuit est adapté à des domaines de charge différents, de préférence, deux domaines de charge différents, en fonction d'une tension de commutation qui peut être amenée à l'entrée (34) du circuit de commutation.

10. Dispositif de circuit selon la revendication 9, caractérisé en ce que l'amplitude d'un signal de commande qui peut être amené à l'électrode de commande de l'interrupteur à semi-conducteur (2) est fonction de la tension de commutation.

11. Dispositif de circuit selon l'une des revendications 9 ou 10, caractérisé en ce que les valeurs de seuil auxquelles réagissent le circuit de surveillance de court-circuit (21 à 26) et le circuit de surveillance de ralenti (13 à 19) sont fonction de la tension de commutation.

12. Dispositif de circuit selon l'une des revendications 9 à 11, caractérisé en ce qu'une limitation de la tension sur l'interrupteur (2) du type semi-conducteur est fonction de la tension de commutation.

Fig. 1

Fig. 2